Europäisches Patentamt

(19) European Patent Office

Office européen des brevets

(11) EP 0 740 314 A1

(12) EUROPEAN PATENT APPLICATION

(43) Date of publication:
30.10.1996 Bulletin 1996/44

(51) Int. Cl.$^6$: H01F 6/00

(21) Application number: 96106363.3

(22) Date of filing: 23.04.1996

(84) Designated Contracting States:
DE FR GB

(30) Priority: 27.04.1995 JP 103415/95
20.11.1995 JP 300939/95

(71) Applicant: HITACHI, LTD.
Chiyoda-ku, Tokyo 101 (JP)

(72) Inventors:
• Hukushima, Kenji
Hitachi-shi, Ibaraki 316 (JP)
• Okada, Michiya
Mito-shi, Ibaraki 311-11 (JP)
• Tanaka, Kazuhide
Hitachi-shi, Ibaraki 319-12 (JP)

(74) Representative: Strehl Schübel-Hopf Groening &
Partner
Maximilianstrasse 54
80538 München (DE)

(54) Superconducting magnet system

(57) A superconducting magnet system comprises a persistent current switching element 1 made of an oxide superconductor, a superconducting magnet 3 made of an oxide superconductor, and a connection part 2 connecting the switching element and the superconducting magnet. The overall resistance of an electrical circuit constituting the magnet system in a persistent current operation mode is not more than $10^{-9}\Omega$. The persistent current switching element 1 is a non-inductive winding coil.

FIG. 1

## Description

## BACKGROUND OF THE INVENTION

Field of the Invention:

The present invention relates to a superconducting magnet system, and to a superconducting coil and a persistent current switch composing the magnet system.

Description of Related Art:

It is effective to use a superconducting magnet by which a very higher current density is obtained in comparison with using a normal conductor, in order to generate a high magnetic field with a compact electromagnet. Operating a superconducting magnet in a persistent current operation mode causes the following merits, that is, improving the stability of a generated magnetic field and the cooling efficiency by suppressing joule heat generation in a current lead, and downsizing a magnetic field generating apparatus to a compact size by separating an exciting source from the apparatus during operation mode. To operate a superconducting magnet in the persistent current mode, it is necessary to provide a persistent current switch such as a thermal controlled switch, a magnetic controlled switch and a mechanical switch. The most popularly used switch is a thermal persistent current switch produced by using an element made by winding a heating wire and a wire made of a base metal with high resistivity such as cupronickel(CuNi)in which niobium-titanium (NbTi) is buried to increase the resistivity in a switch-off state, in a solenoid non-inductive winding coil form, together.

The existing persistent current switch made by using a metal superconducting wire has a low superconduction critical temperature Tc, and a used base metal has a small thermal conductivity. Therefore, such a persistent current switch has the instability problem that a rapid transition to normal conduction( some quenching phenomena ) is easily caused by even a heat generated due to a small disturbance. Although the probability of quenching phenomena in a magnet system can be reduced by using a persistent current switch composed of a plurality of persistent current switching elements connected in parallel each other, the size of a switch becomes large, and the resistivity of each switching element has to be increased for obtaining enough large resistivity of the switch in a switch-off state.

Although solder bonding is used to connect an oxide superconducting coil to the existing persistent current switch using the metal superconductor, there is a limit to the decrease of connection resistance, further the performance of the metal superconductor is deteriorated by the heating in soldering. As one of methods solving the above-mentioned problems, it may be effective to improve the stability of a magnetic system and obtain the favorable low connection resistance by making a persistent current switch with an oxide superconductor having the high Tc. However, in considering operations of the persistent current switch produced by using an oxide superconductor in liquid helium, a very large amount of heat is necessary for the thermal switching because the oxide superconductor is highly stable due to its large thermal margin, and then the large heat input into the liquid helium becomes a problem. Further, it becomes also a problem that a quick switch-on operation of the switch is difficult since it takes a longer time to switch the operation state of the switch from the switch-off state by heating a switching element to the switch-on state by cooling a switching element. To use a magnetic switch is very difficult since an oxide superconductor indicating such a high critical current density Jc as can be used as a persistent current switching element has the high critical magnetic field surpassing that of an oxide superconductor at the vicinity of the temperature of liquid helium.

Since silver popularly used as covering material and base metal for an oxide superconducting wire has a high electrical conductivity, a large length is necessary to obtain enough electrical resistance to turn off a persistent current switch. For example, it needs a wire of kilometer length to obtain $1\ \Omega$ at the temperature of 20-30 K by using a silver sheath wire having a cross-sectional area of about 1 $mm^2$ , and it is not a realistic length.

Furthermore, since a coil used as a persistent current switching element is necessarily a superconducting coil not including a normal conducting connection, or a coil having a very low resistance almost equivalent to that of superconduction material, it is very difficult to use a multi-layer pancake coil having many connection parts for a persistent current switching element.

## SUMMARY OF THE INVENTION

An object of the Invention:

The present invention has been devised in consideration of the above-explained problems, and is aimed at providing a superconducting magnet system comprising a persistent current switch of a high stable performance.

Methods Solving the Problem:

To attain the above-mentioned object, the present invention provides a superconducting magnet system comprising a persistent current switching element made of an oxide superconductor, a superconducting magnet made of an oxide superconductor, and a connection part connecting the persistent current switching element and the superconducting magnet, wherein a whole resistance of an electrical circuit composing the magnet system in a persistent current operation mode is not more than $10^{-9}\ \Omega$

A feature of the persistent current switching element composing the superconducting magnet system of the present invention is that the current switching element is a non-inductive winding coil. If the non-inductive winding coil only have a size enough to possess the resistance necessary for switching off the superconducting magnet system, any shape of a coil is available. Typical shape of coils are a non-inductive winding solenoid coil and a non-inductive winding pancake coil.

As a superconducting wire composing the persistent current switching element of the superconducting magnet system of the present invention, such material as possesses the high resistance at the transition to normal conduction in the persistent current switching-off operation is preferable. For example, an oxide superconducting wire covered with silver base alloy containing one metal of the group of Au, Pt, Mg and Ni is an adequate one.

In the superconducting magnet system of the present system, the persistent current switching element possess a heater, and the persistent current switch is turned off by increasing the temperature of the persistent current switching element with the heater. And, the magnetic field which the persistent current switching element receives is preferably as high as possible within the range in which the critical current density and the stability of superconduction state are secured enough to operate the magnet system, in the superconduction parts except for the persistent current switching element and in the persistent current switching element itself in the persistent current switching-off state. For example, in the case of using $Bi_2Sr_2CaCu_2O_x$ as the superconductor composing the persistent current switching element, the irreversible critical magnetic field of $Bi_2Sr_2CaCu_2O_x$ decrease in accordance with the increase of temperature ( the irreversible critical magnetic field: the boundary field in which, at a given temperature, the region of a non-zero transport critical current density of a superconductor is adjacent to the region of a zero transport critical current density in the superconduction state of the superconductor ). Especially, since this material has the characteristics that the irreversible critical magnetic field rapidly increases below the temperature of 30 K and exceed 1 T, the persistent current switching element using this material can turn off the current switch at the temperature below 30 K, if it is used in the external magnetic field over 1 T. The transport critical current density of this material under the use conditions of the temperature of 4.2 K and the external magnetic field of 1 T decreases only by about 20% in the direction perpendicular to the c axis of the crystal of this material and by about 50 % in the direction parallel to the c axis, in comparison with the current density under the use conditions of 4.2 K and 0 T. Therefore, for example, the high critical current density in the current switching-on state can consist with the current switching-off operation executed by inputting a small heat with the heater.

The superconducting magnet in the superconducting magnet system of the present invention comprises an oxide superconductor such as a solenoid coil or a pancake coil, made of an oxide superconducting wire covered with silver or silver base alloy, containing at least one of a metal group of Au, Pt, Mg and Ni.

The superconductors, in the superconducting magnet system of the present invention, composing the persistent current switching element, the superconducting magnet and the connection part between the switching element and the magnet, is made of at least one of compounds expressed by the following chemical formulas,

$(Bi_y,Pb_{1-y})_{1.5-2.2}Sr_{1.5-2.2}Ca_{0.5-1.3}Cu_{1.5-2.3}O_{7-9}$,

$(Bi_y,Pb_{1-y})_{1.5-2.2}Sr_{1.5-2.2}Ca_{1.5-2.3}Cu_{2.5-3.3}O_{9-11}$,

where $0.1 \leqq y \leqq 1.0$,

$LnBa_2Cu_3O_{6.5-7.2}$ ,

where Ln is at least one of Y and rare earth elements,

$(Tl_{1-y1-y2-y3}Pb_{y1}Bi_{y2}Hg_{y3})_{1.5-2.2}(Sr_{1-y4}Ba_{y4})_{1.5-2.2}Cu_{0.5-1.3}O_{5-7}$,
$(Tl_{1-y1-y2-y3}Pb_{y1}Bi_{y2}Hg_{y3})_{1.5-2.2}(Sr_{1-y4}Ba_{y4})_{1.5-2.2}Ca_{0.5-1.3} Cu_{1.5-2.3}O_{7-9}$,
$(Tl_{1-y1-y2-y3}Pb_{y1}Bi_{y2}Hg_{y3})_{1.5-2.2}(Sr_{1-y4}Ba_{y4})_{1.5-2.2}Ca_{1.5-2.3} Cu_{2.5-3.3}O_{9-11}$,
$(Tl_{1-y1-y2-y3}Pb_{y1}Bi_{y2}Hg_{y3})_{0.5-1.2}(Sr_{1-y4}Ba_{y4})_{1.5-2.2}Cu_{0.5-1.3}O_{4-6}$,
$(Tl_{1-y1-y2-y3}Pb_{y1}Bi_{y2}Hg_{y3})_{0.5-1.2}(Sr_{1-y4}Ba_{y4})_{1.5-2.2}Ca_{0.5-1.3} Cu_{1.5-2.3}O_{6-8}$,
$(Tl_{1-y1-y2-y3}Pb_{y1}Bi_{y2}Hg_{y3})_{0.5-1.2}(Sr_{1-y4}Ba_{y4})_{1.5-2.2}Ca_{1.5-2.3} Cu_{2.5-3.3}O_{8-11}$, and
$(Tl_{1-y1-y2-y3}Pb_{y1}Bi_{y2}Hg_{y3})_{0.5-1.2}(Sr_{1-y4}Ba_{y4})_{1.5-2.2}Ca_{2.5-3.3} Cu_{3.5-4.3}O_{10-12}$,

where    $0 \leqq y1 \leqq 0.9$,
    $0 \leqq y2 \leqq 0.1$,
    $0 \leqq y3 \leqq 0.5$,
    $0 \leqq y1+y2+y3 \leqq 0.5$, and
    $0 \leqq y4 \leqq 1.0$.

Although the superconducting magnet system may include a plurality of kinds of superconductors each of which is made of a different compound, it is preferable that the superconductors are made of the same kind of compound. However, it does not apply to the case in which the connection between the persistent current switching element and the superconducting magnet is carried out by a method except for a heat treatment, for example, the soldering connection.

The superconducting magnet system of the present invention, of which the superconductors composing the magnet system are cooled by dipping the superconductors in liquid coolant, comprises a liquid surface level detector for monitoring a height of liquid coolant,

wherein starting operations of the magnet system comprises the steps of,

exposing the persistent current switching element over the liquid coolant surface by adjusting the height of the liquid coolant surface,
turning off the persistent current switching element by heating the superconductor composing the persistent current switching element with the heater and turning the superconductor into one state of a normal conduction state and an extremely low critical current density state,
exciting the superconducting magnet by turning on electricity in the magnet,
turning on the persistent current switching element by stopping the heating of the switching element, and cooling the switching element by dipping the switching element under the liquid coolant surface, and
stopping the turning on electricity in the magnet and making a persistent current loop in the superconducting magnet system.

As the coolant, a liquid helium is available.

It is desirable to arrange the persistent current switching element so that the size of the height in its length, width and height is minimum. For example, in the case of using a pancake coil in which the size in the direction of the central axis for coil winding is apparently smaller in comparing with the size in the radial direction ( external radius ), being used as the persistent current switching element, it is desirable to arrange the pancake coil so that the central axis is oriented in the vertical direction.

Another feature of the present invention is that the persistent current switching element of the superconducting magnet system is heated or cooled by elevating or lowering only the coolant surface at the vicinity of the current switching element, in case the superconductor composing the superconducting magnet system is cooled by being dipped in liquid coolant.

For example, the superconducting magnet system of the present invention, comprises a partition for partially dividing a space containing the persistent current switching element and the superconducting magnet into two sub-spaces, and valves for adjusting the pressure of gas in each of the sub-spaces divided by the partition,

wherein a method of operating the magnet system comprises the steps of keeping the coolant surfaces of the divided sub-spaces containing the switching element and the magnet over the top faces of the switching element and the magnet by opening( or controlling ) the valves in the persistent current switching-on state, and turning off the persistent current switching element by increasing the temperature of the switching element with lowering only the coolant surface at the vicinity of the switching element under the bottom face of the switching element by heating the coolant with the heater in the closed or reduced opening area state of only the valve at the sub-space containing the switching element.

Another example of the superconducting magnet system comprises two containers in which the persistent current switching element and the superconducting magnet are provided, respectively, wherein the two containers are communicated under the surface of liquid helium in a space containing the two containers, and at least one of the two containers has a valve for adjusting the pressure of gas in the container. Further another example of the superconducting magnet system comprises a cover member covering the side and top faces of the persistent current switching element, a gas releasing pipe projecting from the cover member to the outside of a container including the space which contains the switching element, the connection part and the magnet, and a valve provided in the gas releasing pipe, for adjusting the pressure of gas in the gas releasing pipe and the cover member. In this latter two examples, the persistent current switching elements can be turned on or off by the same operation method executed in the first example.

A feature of a production method of the superconducting magnet system of the present invention is to connect electrically the persistent current switching element made of the oxide superconductor and the superconducting magnet made of the oxide superconductor by a heat treatment so that the whole resistance of an electrical circuit composing the magnet system in the persistent current operation mode is not more than $10^{-9}$ $\Omega$.

In the superconducting magnet system of the present invention, the high thermal stability in the current switching-on state can be obtained since the oxide superconductor which can keep a highly stable superconduction state in comparing with the existing metal superconductor, is used as the persistent current switching element.

Further, for this superconducting magnet system, it is not necessary to adopt the switch composition of paralleled persistent current switching elements for avoiding the quenching phenomena, due to the high thermal stability of this superconducting magnet system. Therefore, since the number of persistent current switching elements composing the persistent current switch can be reduced and the resistance of one persistent current switching element can be also decreased, it is possible to downsize the persistent current switch.

And, since the superconducting magnet system of the present invention has the very low electrical resistance of $10^{-9}\Omega$ in the persistent current operation mode, it becomes possible to provide a superconducting magnet system realizing the very low attenuation ratio of magnetic field which can generate a realistically persistent current loop. Thus, the superconducting magnet system of the present invention in which the high thermal stability can be realized, can be applied to systems such as NMR, MRI, SMES, a magnet system for a magnetically levitated train and so forth, in which the persistent current operation is required or very effective.

For an example of the superconducting magnet system of the present invention in which the magnet system is cooled by liquid coolant, since the coolant surface is lowered under the persistent current switching element in the current switching-off state, and the switching element is quickly cooled by elevating the coolant surface over the switching element by opening/closing the valve in the current switching-on state, the switch-off operation with a small input heat and the quick switch-on operation become realized.

In the superconducting magnet system, since , by arranging the persistent current switching element so that the height size of its length, width and height is minimum, the height change of the coolant surface before and after the current switching-off is suppressed in a small amount, which reduces the coolant amount to be evaporated by inputting the heater, the switch-off operation with a small input heat and the quick switch-on operation can be realized.

In case a pancake coil is used as the persistent current switching element in the superconducting magnet system of the present invention, since the height size of a pancake coil is small and the cooling efficiency of the coil is high, the switch-off operation with a small input heat and the quick switch-on operation become easily realized.

In the superconducting magnet system of the present invention, since the persistent current switch can be turned off with a small input heat by operating the persistent current switching element in a magnet field, it is not necessary to lay the persistent current switching element at a low external magnetic field place for securing the stability likely as a persistent current switching element using the existing metal superconductor which can reduce the length of a lead connecting the persistent current switch and the superconducting magnet.

Further, in the superconducting magnet system of the present invention, since the size of the oxide superconducting wire used for the persistent current switching element is decreased by using silver base alloy having the larger resistivity than silver as sheathing material of the oxide superconducting wire, the persistent current switching element using the oxide superconducting wire can be easily produced, and downsizing of the persistent current switching element becomes possible.

BRIEF DESCRIPTION OF THE DRAWINGS

Fig.1 shows a composition of a superconducting magnet system of an embodiment in the present invention.

Fig.2 shows an outline composition of a magnet system of the embodiment.

Fig.3 shows the detailed structures of a superconducting magnet and a persistent current switching element used in the embodiment.

Fig.4 shows a cross-sectional structure of superconducting wires used for producing a solenoid coil shown in Fig.3.

Fig.5 shows the magnetic field dependency of the resistivity of Ag and Al-Au alloy used to sheath material of a superconducting wire at the temperature of 4.2 K.

Fig.6 shows changes in time of heat input by a heater, surface temperatures of a superconducting magnet and a persistent current switching element, a source current, and a generated magnetic field at the center of the superconducting magnet.

Fig.7 shows changes in time of the magnetic field attenuation ratios of the magnet system of the present invention and a comparative reference magnet system in a long term persistent current mode operation.

Fig.8 shows a composition of a superconducting magnet system of another embodiment.

Fig.9 shows a state of the liquid coolant surfaces in the superconducting magnet system shown in Fig.8, in the persistent current switching-off operation.

Fig.10 shows a composition of a superconducting magnet system of another embodiment.

Fig.11 shows a state of the liquid coolant surfaces in the superconducting magnet system shown in Fig.10, in the persistent current switching-off operation.

Fig.12 shows a composition of a superconducting magnet system of another embodiment.

Fig.13 shows a state of the liquid coolant surfaces in the superconducting magnet system shown in Fig.12, in the persistent current switching-off operation.

Fig.14 shows a composition of a superconducting magnet system of another embodiment.

Fig.15 shows a composition of a superconducting magnet system of another embodiment.

Fig.16 shows an equivalent electrical circuit of the magnet system shown in Fig.15.

Fig.17 shows a cross-sectional structure of a superconducting wire used for composing a non-inductive winding coil shown in Fig.15.

Fig.18 shows a cross-sectional structure of a superconducting wire used for producing a current lead for coil excitation in Fig.15.

Fig.19 shows a combination form of a persistent current switching element and a superconducting magnet of another embodiment.

DETAILED DESCRIPTION OF THE EMBODIMENTS

Hereinafter, embodiments of the present invention will be explained in detail by referring to the drawings.

(1) Embodiment 1

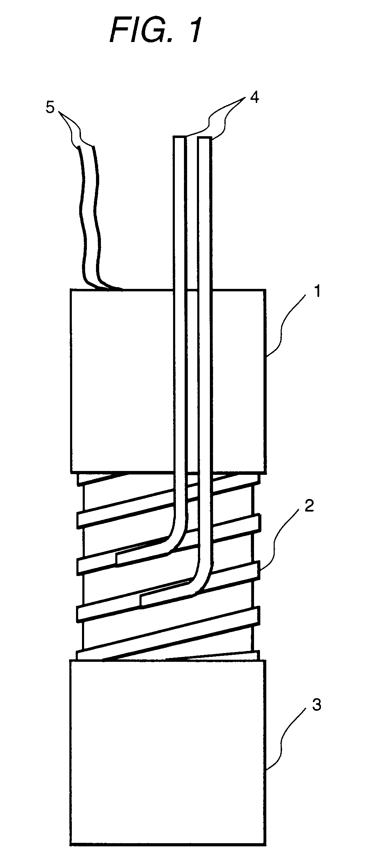

Fig.1 shows a composition of a superconducting magnet system of the present invention.

The magnet system comprises a persistent current switch 1, a connection part 2, a superconducting magnet 3, a current lead for magnet excitation 4 and a current lead for a heater 5. The persistent current switch 1 is a superconducting coil of a non-inductive winding coil produced by winding oxide superconducting wires, and a heater wire is also wound around the outer surface of the current switch 1 also in a non-inductive winding form. And, the current lead for a heater 5 is connected to the heater wire to turn on electricity in the heater wire. The superconducting magnet 3 is also a superconducting coil made of oxide superconducting wires. Each pair of the oxide superconducting wires extending from the persistent current switch element 1 and the superconducting magnet 3 are connected each other at the connection part 2 between the current switch element 1 and the magnet 3, and the current lead for magnet excitation 4 is connected to each of the connected pair of the going and returning oxide superconducting wires. The persistent current switching element 1 is placed over the superconducting magnet 3.

In the following, an example of operation procedures for the magnet system is described.

At first, an example for excitation procedures of the magnet system is shown. By completely dipping the whole persistent current switching element 1 into a coolant, the connection part 2 and the superconducting magnet 3, the superconducting wires in the magnet system are rendered into the superconduction state. Then, the persistent current switching element 1 is heated by turning on electricity in the heater wire on the persistent current switching element 1 via the current lead for a heater 5. The turning-on of electricity in the heater wire is continued until the persistent current switch is turned off by lowering the coolant surface by evaporating the coolant, which exposures the whole persistent current switching element 1 over the coolant surface, and then increases the temperature of the superconducting wires of the switching element sufficiently. Further, a direct current is flowed in the superconducting magnet 3 via the current lead for magnet excitation 4. And, the turning-on of electricity in the heater wire is stopped in the state of keeping the current constantly flowing in the superconducting magnet 3, and the persistent current switch 1 is turned on by pouring the coolant again until the whole persistent current switching element 1 is dipped in the coolant and cooled. Then, the current flowed in the superconducting magnet 3 is decreased and stopped, and it is continued to cool the magnet system by pouring the coolant at the regular period. At this operation state, a current loop is formed by the current flowing in the persistent current switching element 1, the connection part 2 and the superconducting magnet 3, and the superconducting magnet 3 generates a magnetic field whose strength is in proportion to the amount of the current flowing in the loop. Then, the generated magnetic field attenuates at the speed corresponding to the resistance of an electrical circuit in which the loop current is flowing.

Next, an example of demagnetizing procedures for the magnet system is explained. At first, the current value of the loop current is estimated based on the strength of the magnetic field generated by the superconducting magnet, and the direct current of the estimated value is flowed in the magnet system via the current lead for magnet excitation 4 from the outside of the magnet system. Then, the heating and the temperature increase of the persistent current switching element 1 are executed by the same procedures as those in the excitation operations, and the persistent current switch is again turned off. And, the current flowed from the outside is lowered, and the heating of the persistent current switching element 1 is stopped.

In an operational experiment executed by the above-mentioned operational procedures, it took the period $\tau$ ( the attenuation time constant ) of about $1.4 \times 10^5$ s after the flowing of the current in the superconducting magnet 3 via the current lead for magnet excitation 4 was stopped until the magnetic field generated by the formed current loop at the superconducting magnet 3 attenuated by 1/e. Then, since the persistent current switching element 1 was a non-inductive winding coil and the inductance of the superconducting magnet is $1.0 \times 10^{-4}$ H, the inductance L of the equivalent electrical circuit of the magnet system in which the loop current was formed was $1.0 \times 10^{-4}$ H. Thus, the whole electrical resistance R of the equivalent circuit corresponding to the current loop was estimated as not more than $0.71 \times 10^{-9}$ $\Omega$ from the relation of $\tau = L/R$ .

(2) Embodiment 2

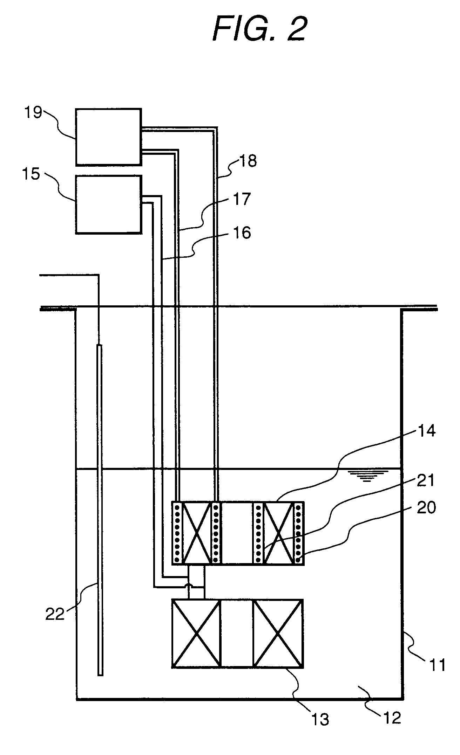

Fig.2 shows an outline composition of the superconducting magnet system of the present invention.

A superconducting magnet 13 and a persistent current switching element 14 are dipped in liquid helium 12 contained in a cryostat 11. The superconducting magnet 13 and the persistent current switching element 14 are connected by a connection part made of a superconducive wire, and further the connection part and the a source for coil excitation 15 provided outside of the cryostat 11 are connected via current leads 16 for a coil. At the persistent current switching element 14, heaters 20 and 21 for heating a persistent current switch, connected to a source for heating 19 via current leads 17 and 18 for heaters, are provided. And, a liquid helium surface level detector 22 is provided in the cryostat 11.

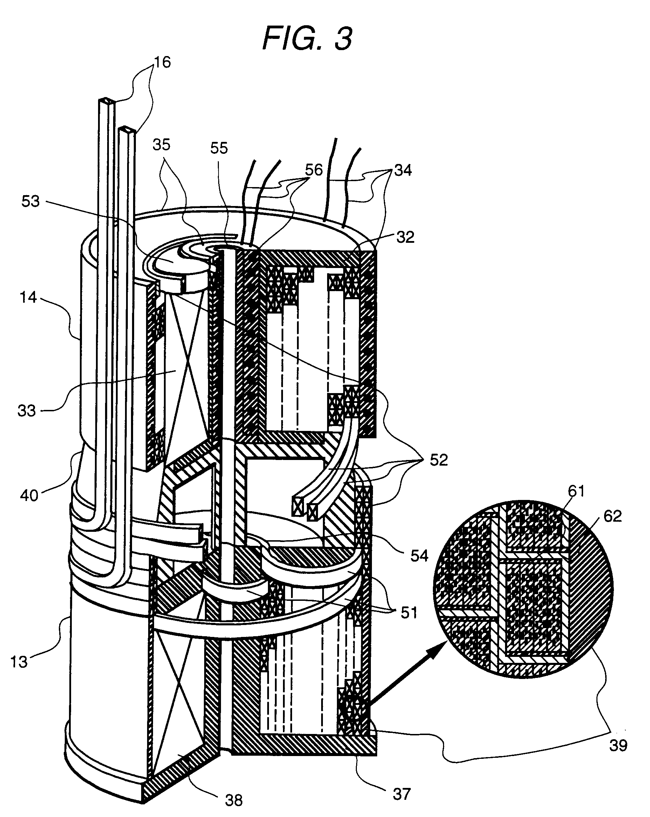

Fig.3 shows detailed structures of the superconducting magnet 13 and the persistent current switching element 14.

The persistent current switching element 14 is composed of a bobbin 32 made of stainless steel, a non-inductive winding coil 33, a heater wire 34 and an impregnating material member 35. And, the superconducting magnet 13 is composed of a bobbin 37 made of stainless steel, a solenoid coil 38 and an impregnating material member 39. The persistent current switching element 14 and the superconducting magnet 13 are separated and connected with a spacer 40 made of stainless steel. The superconducting wires of the non-inductive winding coil 33 and the solenoid coil 38 are wound as overlapping each other on the surface of the spacer 40, and connected each other via silver paste applied on the surface. Insulating tapes on the coils is removed from the connection part. Current leads 16 for magnet excitation are connected to the non-inductive winding coil 33 and the solenoid coil 38 at the connection part. The superconductors and the current lead are sintered and connected by taking in the whole of the conductors and the current leads in an electric furnace, and performing heat treatment for the conductors and the current leads under the conditions of 878 °C for 10 min in oxygen gas, and the conditions of 800 °C for 20 h in mixed gas of oxygen and nitrogen. After the above-mentioned heat treatment, heater wires 34 are wound on the coil 33, a bobbin 56 for winding the heater wires is inserted into the coil 33, and the persistent current switching element 14 and the superconducting magnet 13 are coated with the impregnating material members 35 and 39, respectively.

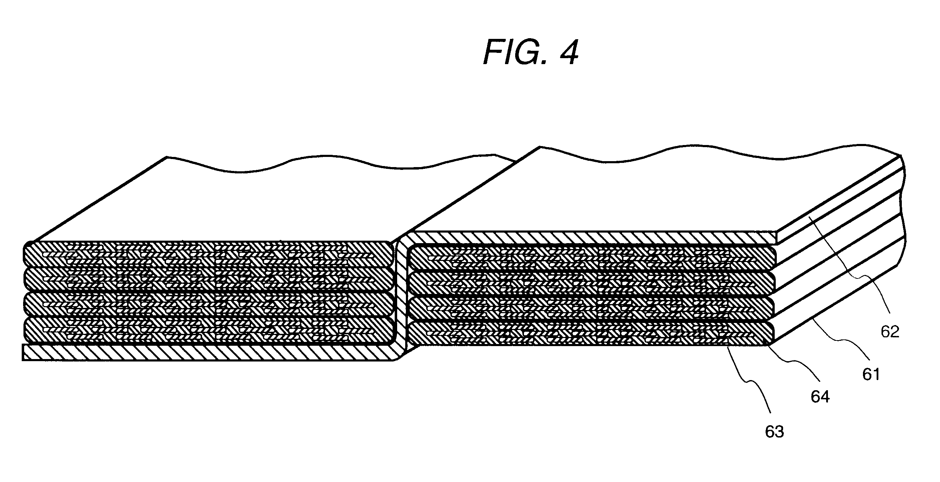

Fig.4 shows a cross-sectional structure of a Bi series superconducting wires 51 used for producing the solenoid 38. The superconductor is composed of a tape shaped wire 61 made of superconducting cores 63 and sheathing material, and a tape shaped insulator 62.

In the following, production process of the Bi series superconducting wire 51 is explained. A silver pipe of the outer diameter of 6 mm and the inner diameter 5 mm is filled up with powder of oxide superconducting material $Bi_2Sr_2CaCu_2O_X$, and the both ends of the pipe are crushed. And, the pipe is drawn to the diameter of 1.0 mm, and cut in the predetermined length. Nineteen pipes of the diameter of 1 mm are bundled and inserted into a silver or silver base alloy pipe of the outside diameter of 6 mm and the inside diameter of 5.2 mm. Then, the both ends are crushed. Further, the pipe containing the 19 pieces of the drawn pipes is also drawn to the diameter of 0.7 mm, and the 19-core tape shaped wire 61 of the width of 2 mm and the thickness of 0.125 mm is obtained by rolling the pipe of the diameter of 0.7 mm. Further, a wire bundle is made by superposing 4 of the 19-core tape shaped wires. Then, the solenoid coil 38 is produced by covering the wire bundles with an alumina tape shaped insulator 62 so that the tape shaped insulator 62 covers the top face of a wire bundle and the bottom face of the neighboring wire bundle, alternatingly, and winding the wire bundles covered with the tape shaped insulator 62 on a bobbin 37 in a solenoid form.

The starting part of winding the conductor made of the wire bundle on the bobbin is turned with the predetermined curvature along a conductor turning guide part 54 provided at the top part of the bobbin 37, and leaded to the connection part with the non-inductive coil 33 so that the wire bundles are overlapped on the ending part of the non-inductive coil winding in the same direction as the direction of the non-inductive coil 33.

The structure of the Bi series superconducting wires 52 used for producing the non-inductive winding coil 33 in Fig.3 is the same structure as that of the Bi series superconducting wires 52 shown in Fig.4 except that silver-gold alloy ( Ag-10 at% Au ) is used for the sheath material 64. And, the starting part of winding the conductor for the coil 33 is turned with the predetermined curvature along a conductor turning guide part 53 provided at the top part of the bobbin 32.

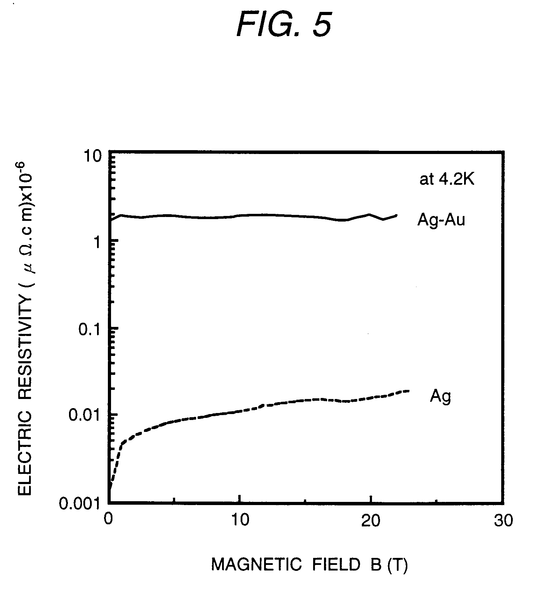

For a comparative reference example, a comparative magnet system was produced by soldering a persistent current switching element having the same structure as that of the persistent current switching element 14 and a solenoid coil made of Nb-Ti superconducting wires having the same inductance L as that of the superconducting magnet 13. In Fig.5, is shown the measured magnetic field dependency of the electrical resistance of the sheath material Ag and Ag-Au alloy ( Ag-10 at% Au ) for superconducting wires composing a superconducting magnet system, at the temperature of 4.2 K. The resistance values of Ag-Au alloy ( Ag-10 at% Au ) in the magnetic field of 0 and 20 T are $1.7\times10^{-6}$ and $2.0\times10^{-6}$ $\mu\Omega$ • cm, respectively. Since the length of a wire used for making the non-inductive winding coil 33 for the persistent current switching element is about 13 m, the resistance in the normal conduction at the switching-off state is at least more than 1 $\Omega$ even without an external magnetic field which is the resistance enough to turn off the persistent current switching element. The resistance value at the switching-off state does not decrease and rather increases if the magnet system is placed in the external magnetic field of more than 20 T. And, it is known from Fig.5 that using Ag as the sheath can give only the resistance lower by two figures than that in the embodiment even if the magneto-resistance is utilized by applying the magnetic field of 20 T to coils, at the switching-off state with the same composition of a coil as that of the coils in the embodiment.

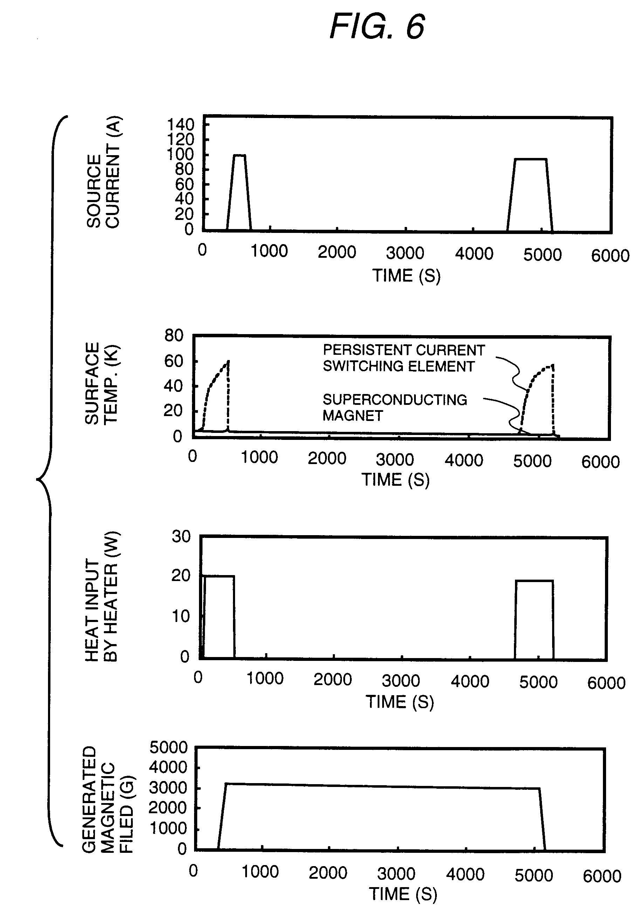

In Fig.6, data obtained at exciting and degaussing test operated by the procedures similar to those shown in the embodiment 1. The figure shows changes in time of heat input by the heater, surface temperatures of the superconducting magnet 13 and the persistent current switching element 14, a source current of a source for exciting the coils and magnetic field generated in the center of the superconducting magnet 13. From the figure, it is known that the persistent current switch normally operates and a persistent current operation mode is realized corresponding to the operations of the current switch in the magnet system.

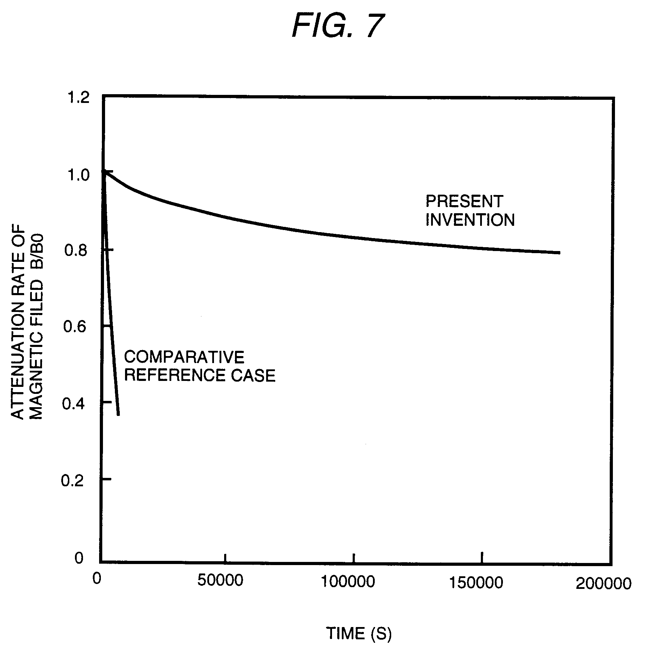

Fig.7 shows changes in time of attenuation rates of magnetic field $B/B_0$ in long time persistent current mode operations for the magnet system of the present invention and the magnet system for comparative reference, where B is the magnetic flux density of the generated magnetic field at a time t and $B_0$ is the magnetic flux density of the generated magnetic field at the time 0. If B is expressed by a function of $B_0$, the attenuation time constant $\tau$ and a elapsed time t from the time 0, that is,

$B=B_0 \times e^{-t/\tau}$ , the time constants $\tau$ of the magnet system of the present invention and the comparative reference magnet system are estimated as $8 \times 10^5$ s and $7 \times 10^3$ s, respectively. Since the inductances of both magnet system are $2 \times 10^{-4}$ H, it is known that the total electric resistance of a persistent current loop circuit is less than $2.5 \times 10^{-10}$ $\Omega$ in the magnet system of the present invention and less than $2.9 \times 10^{-8}$ $\Omega$ in the comparative reference system.

(3) Embodiment 3

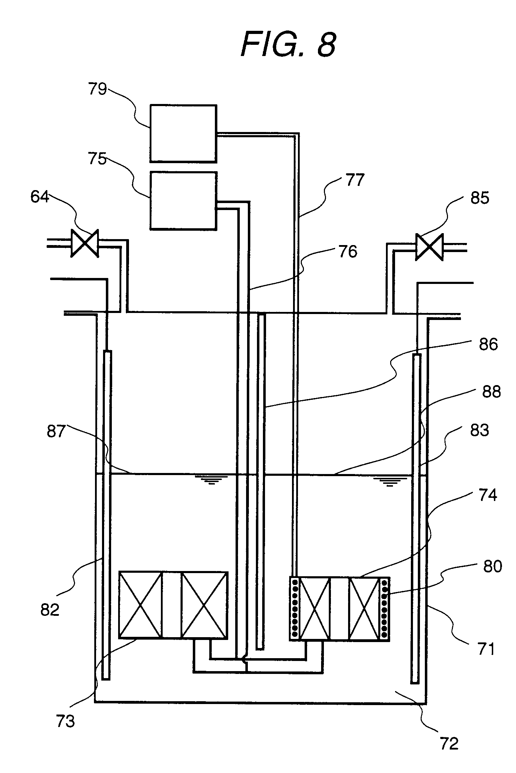

Fig.8 shows an outline composition of a superconducting magnet system of the present invention.

A superconducting magnet 73 and a persistent current switching element 74 are dipped in liquid helium 72 in a cryostat 71, and a space in the cryostat 71 is divided into two sub-spaces by a partition 86 including a vacuum insulating layer in the inside of its member. Valves 84 and 85 for adjusting gas pressure, and liquid helium surface level detectors 82 and 83 are provided at the two divided sub-spaces, respectively. The superconducting magnet 73 and the persistent current switching element 74 are connected with a superconducting wire. Further, the connection part is connected to a source 75 for coil excitation provided outside the cryostat 71 via a current lead for coils 76. At the persistent current switching element 74, a heater 80 for heating the persistent current switch is provided, which is connected to a source for the heater 79 via a current lead for the heater 77. In letting the gas pressure in the cryostat 71 equal or almost equal to the atmospheric pressure by opening the valves 84 and 85 for adjusting gas pressure, the levels 87 and 88 of the liquid helium in the divided sub-spaces have the same height as shown in Fig.8.

As to a non-inductive winding coil used for the persistent current switching element 74, a superconducting wire used for the superconducting magnet 73, the sizes of the coils and the compositions of the superconductors are the same as ones used in the embodiment 2.

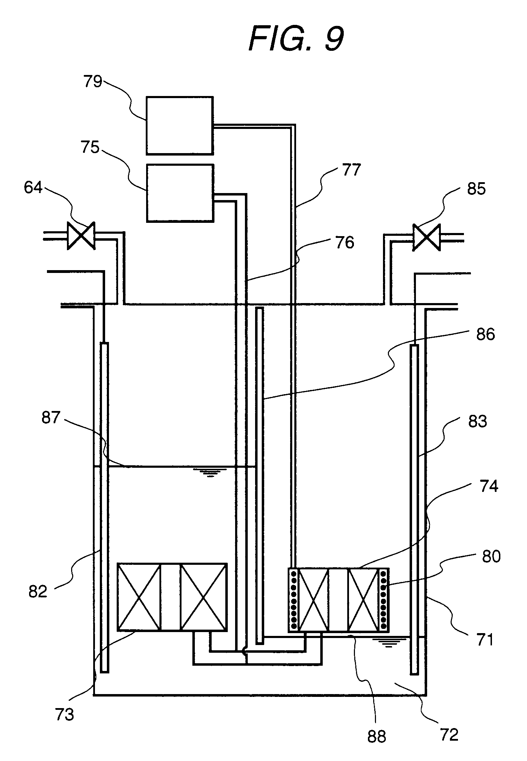

Although the operation procedures of this magnet system is fundamentally the same as the procedures explained in the embodiment 1, the electricity is turned on in the heater 80 for heating the persistent current switch in the state of closing the valve 85 for adjusting the pressure of the gas in the sub-space containing the persistent current switching element 74. By using the magnet system of this embodiment, a higher- speed switching-off operation with less input heat becomes possible as compared with the case in which the partition 86 and the valve 85 for adjusting gas pressure are not provided in the cryostat, since the amount of liquid helium necessary to expose the persistent current switching element 74 over the surface of liquid helium can be reduced. In Fig.9, the state of the liquid helium surfaces at the turned-off operation of the persistent current switch is shown.

And, in turning on the persistent current switch again, since the persistent current switching element 74 can be quickly cooled by feeding liquid helium to the cryostat from the outside of the magnet system and simultaneously opening the valve 85 for adjusting gas pressure, a higher-speed switching-on operation is also possible in comparison with the existing magnet system.

(4) Embodiment 4

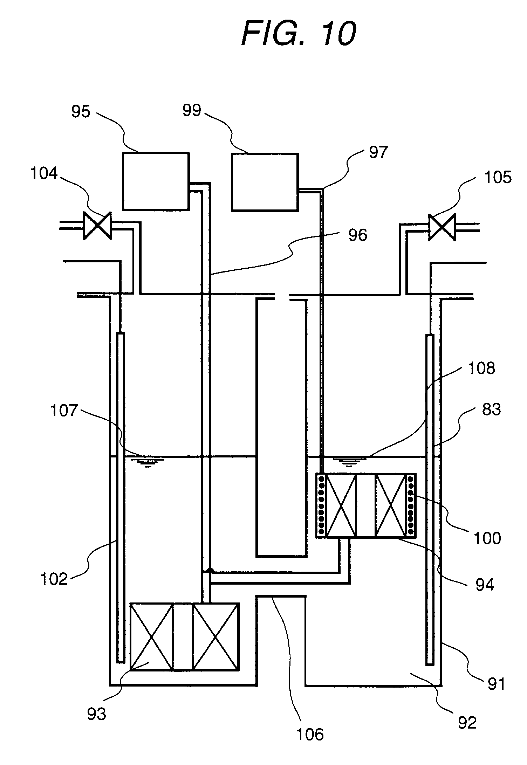

Fig.10 shows an outline composition of a superconducting magnet system of the present invention.

In liquid helium 92 contained in a cryostat 91, a superconducting magnet 93 and a persistent current switching element 94 are dipped, and the cryostat 91 has such a structure that two cryostat are communicated each other via a cryostat communicating part 106 under the liquid helium surface. And, in the two spaces of the cryostat, liquid helium level detectors 102 and 103, and valves 104 and 103 for adjusting gas pressure are provided, respectively. The superconducting magnet 93 and the persistent current switching element 94 are connected with a superconducting wire through the cryostat communicating part 106, and the connection part of the superconducting wire is further connected to a source for coil excitation 95 via a current lead for a coil 96. At the persistent current switching element 94, a heater 100 for heating a persistent current switch connected to a source for a heater 99 via a current lead for a heater 97 is provided. In letting the gas pressure of the cryostat 91 equal or almost equal to the atmospheric pressure by opening the valves 104 and 105 for adjusting gas pressure, the levels 107 and 108 of liquid helium have the same height as shown in Fig.10

As to a non-inductive winding coil used for the persistent current switching element 94, a superconducting wire used for the superconducting magnet 93, the sizes of the coils and the compositions of the superconductors are the same as ones used in the embodiment 2.

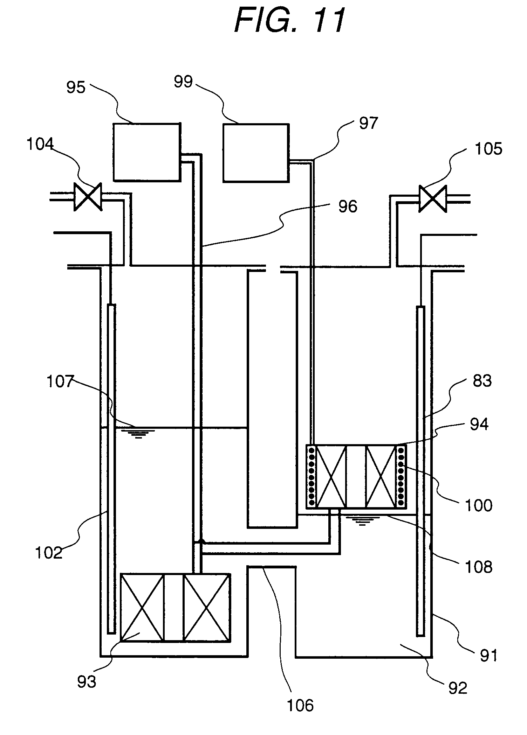

Although the operation procedures of this magnet system are fundamentally the same as the procedures explained in the embodiment 1, the electricity is turned on in the heater 100 for heating the persistent current switch in the state of closing the valve 105 for adjusting the pressure of the gas in the space containing the persistent current switching element 94. By using the magnet system of this embodiment, a higher-speed switching-off operation with less input heat becomes possible, since the amount of liquid helium necessary to expose the persistent current switching element 94 over the surface of liquid helium can be reduced as compared with the case in which the cryostat is not divided. In Fig.11, the state of the liquid helium surfaces at the turned-off operation of the persistent current switch is shown.

And, in turning on the persistent current switch again, since the persistent current switching element 94 can be quickly cooled by feeding liquid helium to the cryostat from the outside of the magnet system and simultaneously opening the valve 105 for adjusting gas pressure, a higher-speed switching-on operation is also possible.

## (5) Embodiment 5

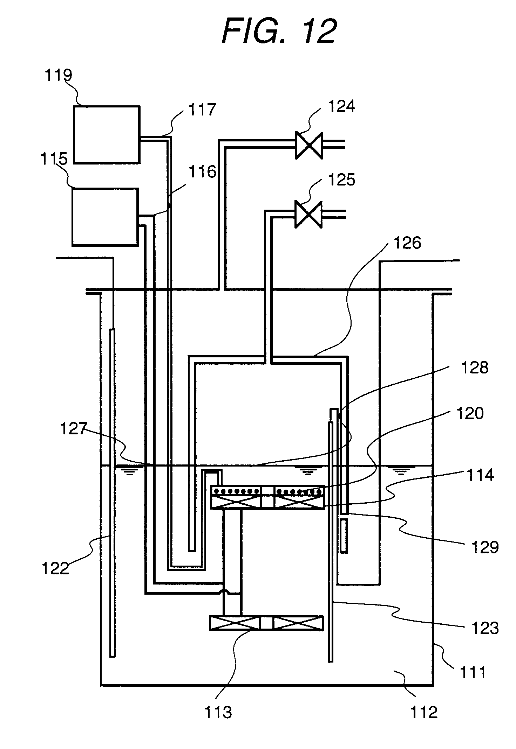

Fig.12 shows an outline composition of a superconducting magnet system of the present invention.

In liquid helium 112 contained in a cryostat 111, a superconducting magnet 113 and a persistent current switching element 114 are dipped, and the cryostat 111 has a cover 126 covering the side face and top faces of the persistent current switching element 114, by which the space in the cryostat 111 is partially partitioned. The cover 126 has a vacuum heat insulating layer in the inside of a member composing the cover 126, and a penetrating hole 129 is formed at the side member of the cryostat 111, which is set at the position under the level of the bottom face of the persistent switching element 114. And, in the two sub-spaces, partitioned by the cover 126, of the cryostat, liquid helium level detectors 122 and 123, and valves 124 and 125 for adjusting gas pressure are provided, respectively. The superconducting magnet 113 and the persistent current switching element 114 are connected with a superconducting wire, and the connection part of the superconducting wire is connected to a source 115 for coil excitation via a current lead for a coil 116. At the persistent current switching element 114, a heater 120 for heating a persistent current switch, connected to a source for a heater 119 via a current lead 117 for a heater, is provided. In rendering the gas pressure of the cryostat 111 equal or almost equal to the atmospheric pressure by opening the valves 124 and 125 for adjusting gas pressure, the levels 127 and 128 of liquid helium have the same height as shown in Fig.12.

Each of a non-inductive coil composing the persistent current switching element 114 and a superconducting wire composing the superconducting magnet 113 is produced by the same process as that mentioned in the embodiment 2. In this embodiment, three kinds of magnet systems are produced and used, for each of which one of compounds $Bi_2Sr_2CaCu_2O_X$, $Bi_2Sr_2Ca_2Cu_3O_X$, and $Tl_2Sr_{1.6}Ba_{0.4}Ca_2Cu_3O_X$ is used as superconducting material for making of a superconducting wire. And, each of the non-inductive coils of the persistent current switching element 114 and the superconducting magnet 113 is a pancake coil produced by winding an alumina insulating tape of the thickness of 0.1 mm over-lapped on the tape shaped superconducting wires superimposed in 4 layers, in a pancake form. The sizes of the superconducting wire are the same as those mentioned in the embodiment 2, and the sizes of the pancake coil are as follows, that is, the outer diameter is 46 mm, the inner diameter is 16 mm, and the height is 2 mm.

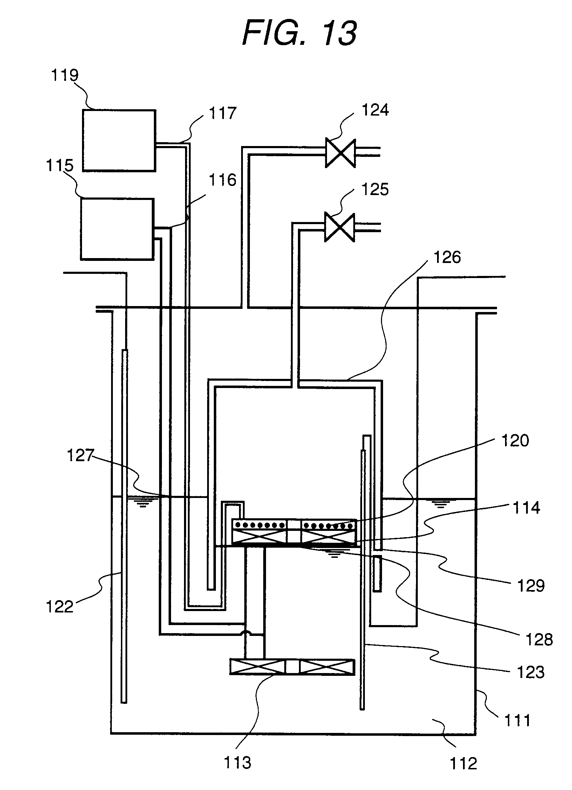

Although the operation procedures of this magnet system are fundamentally the same as the procedures explained in the embodiment 1, the electricity is turned on in the heater 120 for heating the persistent current switch in the state of closing the valve 125 for adjusting the pressure of the gas in the space containing the persistent current switching element 114. By using the magnet system of this embodiment, a higher-speed switching-off operation with less input heat becomes possible, since the amount of liquid helium necessary to expose the persistent current switching element 114 over the surface of liquid helium can be reduced as compared with the case in which the cover for partitioning a space in the cryostat is not provided. In Fig.13, the state of the liquid helium surface at the turned-off operation of the persistent current switch is shown.

And, in turning on the persistent current switch again, since the persistent current switching element 114 can be quickly cooled by feeding liquid helium to the cryostat from the outside of the magnet system and simultaneously opening the valve 125 for adjusting gas pressure, a higher-speed switching-on operation is also possible.

Each of the three kinds of magnet systems produced by using the superconducting material of $Bi_2Sr_2CaCu_2O_X$, $Bi_2Sr_2Ca_2Cu_3O_X$, and $Tl_2Sr_{1.6}Ba_{0.4}Ca_2Cu_3O_X$ , is operated by the same procedures as those mentioned in the embodiment 1. Then, from the results of the operations, it has been confirmed that each of the persistent current switches adequately operate and the persistent current mode operation is possible in those magnet systems. The attenuation time constants $\tau$ of the magnetic field were $2.7\times10^4$ s, $2.5\times10^4$ s and $2.2\times10^4$ s, respectively. Since the inductance L of the pancake coil used for the superconducting magnet 113 is $2\times10^{-5}$ H in all the three cases, the resistances of the loop current circuits were estimated as $7.4\times10^{-10}$ $\Omega$, $8.0\times10^{-10}$ $\Omega$ and $9.1\times10^{-10}$ $\Omega$, respectively.

## (6) Embodiment 6

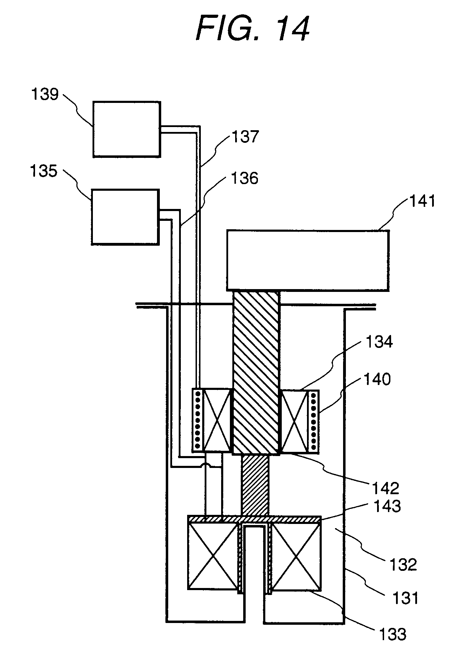

Fig.14 shows an outline composition of a superconducting magnet system of the present invention.

A cryostat 131 contains a persistent current switching element 143 provided at the first stage of a GM ( Gifford-McMahon ) refrigerator 141 and a superconducting magnet provided at the second stage of the refrigerator 141 which are cooled by the refrigerator 141. The superconducting magnet 133 and the persistent current switching element 134 are connected with a superconducting wire, and the connection part of the superconducting wire is connected to a source for coil excitation 135 via a current lead 136 for a coil. At the persistent current switching element 134, a heater 140 for heating a persistent current switch connected to a source 139 for a heater via a current lead 137 for a heater is provided. Further, a space 131 in the cryostat 132 composes a vacuum heat insulating space.

As to a non-inductive winding coil used for the persistent current switching element 134, a superconducting wire used for the superconducting magnet 133, the sizes of the coils and the compositions of the superconductors are the same as ones used in the embodiment 2 except that the inner diameter of the non-inductive winding coil composing the persistent current switching element 134 is increased and the length of a superconducting wire used for the switching element is about 8 m. Although the resistance at the switching-off operation of the persistent current switching element 134 decreases by 40 %, the persistent current mode operation is also possible by the same operational procedures for temperature increasing, coil cooling, turning on electricity in coils, etc. as those mentioned in the embodiment 1, even in case the refrigerator cooling method is adopted in place of the liquid helium cooling method. The measured time constant $\tau$ was $2\times10^5$ s, and the resistance of the current loop circuit was estimated $0.8\times10^{-9}$ $\Omega$

(7) Embodiment 7

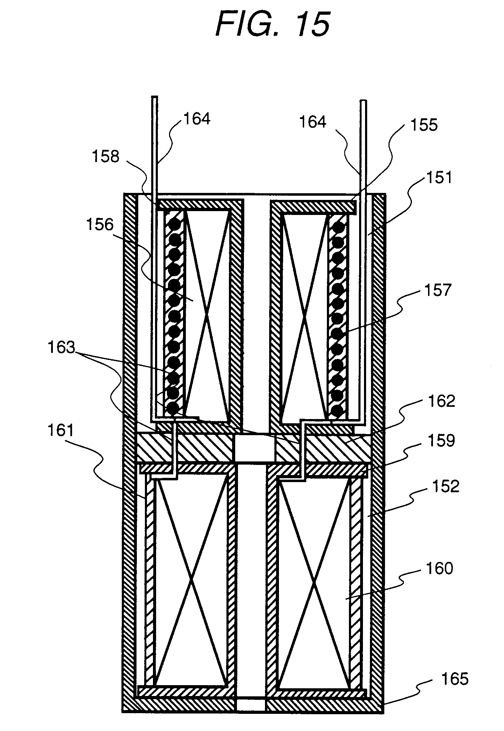

Fig.15 shows an outline composition of a superconducting magnet system of the present invention.

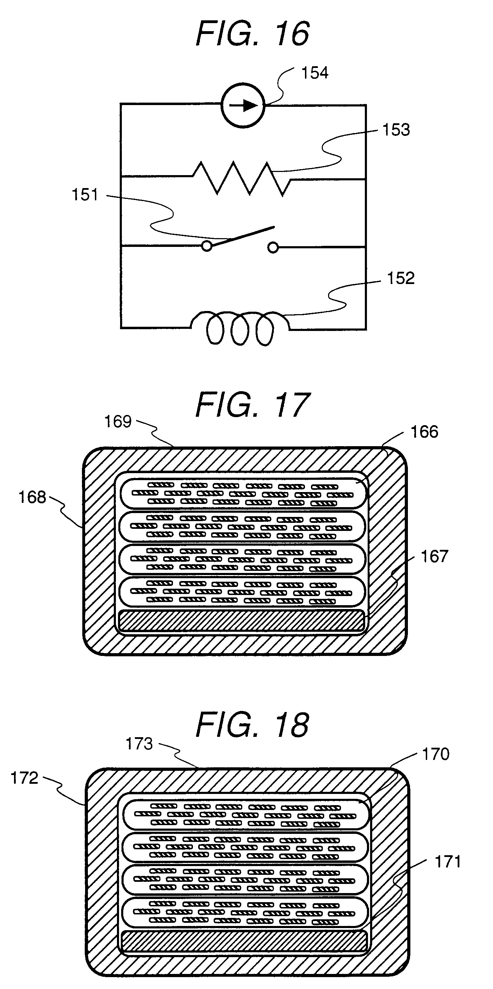

The system composed of a persistent current switching element and a superconducting magnet shown in Fig 15 is equivalently represented by an electrical circuit shown in Fig.16. In the circuit shown in Fig.16, a persistent current switching element 151, a superconducting magnet 152 and a protective resistor 153 are connected in parallel to a source 154 for coil excitation.

In Fig.15, the persistent current switching element 151 comprises a stainless steel bobbin 155, a non-inductive winding coil 156, a heater wire 157 and an impregnating material member 158, and the superconducting magnet 152 comprises a stainless steel bobbin 159, a solenoid coil 160 and an impregnating material member 161. The persistent current switching element 151 and the superconducting magnet 152 are separated each other by a stainless steel spacer 162, and the non-inductive winding coil 156 and the solenoid coil 160 are connected each other via a connection lead 63. Further, a current 164 lead for magnet excitation is connected to the non-inductive winding coil 156 at the connection part of the connection lead 163. And, the connections of the leads are carried out by processing the sintering heat treatment for both of the persistent current switching element 151 and the superconducting magnet 152 which are taken into an electric furnace. After the above-mentioned heat treatment for the connections of the leads, the persistent current switching element 151 and the superconducting magnet 152 are confined in a stainless steel cylindrical case of the outer diameter of 50 mm and the height of 200 mm, in one united body.

Fig.17 shows a cross-sectional structure of a Bi series superconducting wire used for producing the non-inductive winding coil 156 shown in Fig.15. The Bi series superconducting wire 169 is a superconducting wire of the width of 4 mm and the thickness of 2 mm having such a structure that 4 pieces of Ag-Au alloy sheathed tape shaped multi-conductor wires 166 made of $Bi_2Sr_2CaCu_2O_8$, of which the width is 2 mm and the thickness is 0.125 mm, and one reinforcement metal tape 167 are covered together with ceramic insulating material 168.

Fig.18 shows a cross-sectional structure of a Bi series superconducting wire used for producing the solenoid coil 160, the connection lead 163 and the current lead for magnet excitation 164 shown in Fig.15. Although the shape and the sizes of the conductor are the same as those of the Bi series superconducting wires 169 shown in Fig.17, the tape shaped multi-core superconducting wire 170 is sheathed with Ag.

The circuit shown in Fig.16 was equivalently realized by inserting the persistent current switching element 151 and the superconducting magnet into a bias coil, and the test of turning on electricity in the circuit was executed under the condition of dipping the circuit in liquid helium. The direction of magnetic field generated at the center of the bias coil was parallel to the central axis of the superconducting magnet 152, and the strength of the magnetic field was 20 T. And, the persistent current switching element 151 was turned off by turning on electricity in the heater wire 157 of the switching element 151, and the superconducting magnet 152 was excited by turning on the electricity of 100 A in the magnet 152. Then, it was confirmed that turning-off of the persistent current switching element 151 and the superconducting magnet 152 were normally operated. The magnetic field at the center of the superconducting magnet was 20.2 T. Further, the persistent current switching element 151 was turned on by stopping the turning-on electricity in the heater wire 157, and the exciting source was disconnected from the magnet 152. Then, the attenuation of the magnetic field in the magnet 152 was monitored, and the quenching of the switching element 151 was not generated during 96 h. Thus, the normal operation of the switching element 151 was confirmed.

(8) Embodiment 8

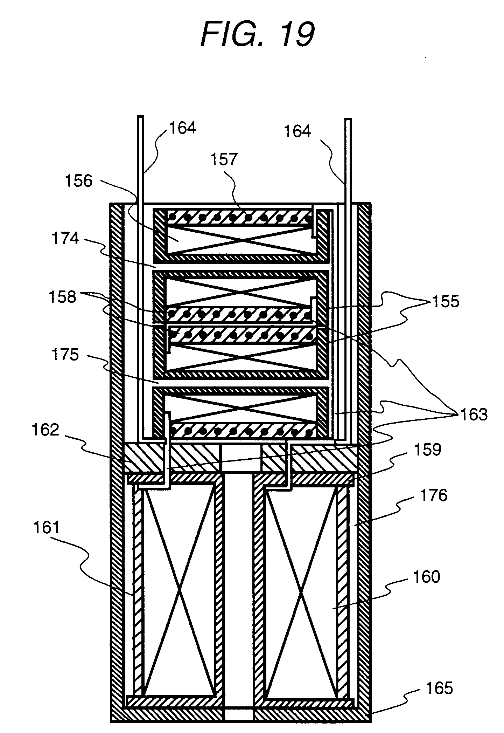

Fig.19 shows a composition of a persistent current switching element and a superconducting magnet of an embodiment wherein persistent current switching elements 174 and 175, and a superconducting magnet 176, corresponding to the persistent current switching element 151 and the superconducting magnet 152 in the embodiment 7, respectively, are combined. In this embodiment, the persistent current switching element 174 and 175 are laid in the transverse direction. Thus, the central axes of the persistent current switching elements 174 and 175 intersect the central axis of the superconducting magnet 176 at right angles. As to those persistent current switching elements, the same test as that in the embodiment 7 was carried out, and the normal operations of the switching elements were also confirmed. Further, the input heat necessary to turn off the switching elements was less than a half of one needed in the embodiment 7.

With the superconducting magnet of the present invention, in comparison with the existing superconducting magnet systems which have been devised, the persistent current mode operations with the higher thermal stability can be realized even under the condition of the high magnetic field caused by the superconducting magnet. Further, the thermal type persistent current switch made of the oxide superconductor can be downsized, and then the switching-off operations with less input heat and the higher-speed switching-on operations are possible.

**Claims**

1. A superconducting magnet system comprising:

   a persistent current switching element (1) made of an oxide superconductor,
   a superconducting magnet (3) made of an oxide superconductor, and
   a connection part (2) connecting said switching element (1) and said magnet (3),
      wherein the electrical resistance of an electric circuit composing said magnet system in a persistent current operation mode is not more than $10^{-9}$ $\Omega$

2. The system of claim 1, wherein said switching element (1) is a non-inductive winding coil, preferably a solenoid coil or pancake coil.

3. The system of claim 1 or 2, wherein said switching element (1) is made of an oxide superconductor covered with silver base alloy containing at least one of the metal elements Au, Pt, Mg and Ni.

4. The system of any of claims 1 to 3, wherein a heater is provided at said switching element (1).

5. The system of any of claims 1 to 4, wherein said magnet (3) is a solenoid coil or pancake coil.

6. The system of any of claims 1 to 5, wherein said magnet (3) is made of an oxide superconductor covered with silver base alloy containing at least one of the metal elements Au, Pt, Mg and Ni,

7. The system of any of claims 1 to 6, wherein the oxide superconductor constituting said switching element (1), said magnet (3) and said connection part (2) is made of at least one of the compounds expressed by the following chemical formulae:

$(Bi_y,Pb_{1-y})_{1.5-2.2}Sr_{1.5-2.2}Ca_{0.5-1.3}Cu_{1.5-2.3}O_{7-9}$,

$(Bi_y,Pb_{1-y})_{1.5-2.2}Sr_{1.5-2.2}Ca_{1.5-2.3}Cu_{2.5-3.3}O_{9-11}$,

where $0.1 \leq y \leq 1.0$,

$LnBa_2Cu_3O_{6.5-7.2}$,

where Ln is at least one of Y and rare earth elements,

$(Tl_{1-y1-y2-y3}Pb_{y1}Bi_{y2}Hg_{y3})_{1.5-2.2}(Sr_{1-y4}Ba_{y4})_{1.5-2.2}Cu_{0.5-1.3}O_{5-7}$,

$(Tl_{1-y1-y2-y3}Pb_{y1}Bi_{y2}Hg_{y3})_{1.5-2.2}(Sr_{1-y4}Ba_{y4})_{1.5-2.2}Ca_{0.5-1.3}Cu_{1.5-2.3}O_{7-9}$,

$(Tl_{1-y1-y2-y3}Pb_{y1}Bi_{y2}Hg_{y3})_{1.5-2.2}(Sr_{1-y4}Ba_{y4})_{1.5-2.2}Ca_{1.5-2.3}Cu_{2.5-3.3}O_{9-11}$,

$(Tl_{1-y1-y2-y3}Pb_{y1}Bi_{y2}Hg_{y3})_{0.5-1.2}(Sr_{1-y4}Ba_{y4})_{1.5-2.2}Cu_{0.5-1.3}O_{4-6}$,

$(Tl_{1-y1-y2-y3}Pb_{y1}Bi_{y2}Hg_{y3})_{0.5-1.2}(Sr_{1-y4}Ba_{y4})_{1.5-2.2}Ca_{0.5-1.3}Cu_{1.5-2.3}O_{6-8}$,

$(Tl_{1-y1-y2-y3}Pb_{y1}Bi_{y2}Hg_{y3})_{0.5-1.2}(Sr_{1-y4}Ba_{y4})_{1.5-2.2}Ca_{1.5-2.3}Cu_{2.5-3.3}O_{8-10}$, and

$(Tl_{1-y1-y2-y3}Pb_{y1}Bi_{y2}Hg_{y3})_{0.5-1.2}(Sr_{1-y4}Ba_{y4})_{1.5-2.2}Ca_{2.5-3.3}Cu_{3.5-4.3}O_{10-12}$,

where  $0 \leq y1 \leq 0.9$,
       $0 \leq y2 \leq 0.1$,
       $0 \leq y3 \leq 0.5$,
       $0 \leq y1+y2+y3 \leq 1.0$, and
       $0 \leq y4 \leq 1.0$.

8. The system of any of claims 1 to 7, wherein superconducting wires (4) extending from said switching element (1) and said magnet (3) are connected as overlapping each other at said connection part (2).

9. The system of any preceding claims comprising at least one liquid surface level detector (22) for monitoring the height of a liquid coolant, which is preferably helium, wherein the operations of said magnet system is started by the following steps:

   exposing said switching element (14) over said liquid coolant surface by adjusting the height of said liquid coolant surface,
   turning off said switching element (14) by heating said superconductor constituting said switching element with said heater (19) and turning said superconductor into a normal conduction state or a low critical current density state,
   exciting said magnet (13) by turning on electricity in said magnet,
   turning on said switching element (14) by stopping the heating of said switching element, and cooling said switching element by dipping it under said liquid coolant surface, and
   turning off the electricity in said magnet (13) and forming a persistent current loop in said superconductive magnet system.

10. The system of claim 9, wherein said switching element (14) is arranged so that its height is the smallest dimension of its width, length and height.

11. The system of claim 9 or 10, wherein said switching element (14) is a non-inductive winding pancake coil having its central axis extending vertically.

12. The system of any of claims 9 to 11, wherein said switching element (14) is heated and cooled by elevating and lowering said coolant surface in the vicinity of said switching element only.

13. The system of any of claims 9 to 12, further comprising a partition (86) for partially separating the space containing said switching element (74) from that containing said superconducting magnet (73), and valves (64, 85) for adjusting the gas pressure in each of said space.

14. The system of any of claims 9 to 12, wherein said switching element (100) and said superconducting magnet (93) are contained in two containers, which communicate under the surface of liquid helium, at least one of said two containers having a valve (104, 105) for adjusting the gas pressure therein.

15. The system of any of claims 9 to 14, further comprising:

    a cover member for covering the side and top faces of said persistent current switching element;
    a gas releasing pipe projecting from the cover member to the outside of a container which contains said switching element, said connection part and said magnet; and
    a valve provided in said gas releasing pipe, for adjusting the pressure of gas in said gas releasing pipe and said cover member.

16. The system of claim 9, wherein at least for turning off said switching element, at least a part of said switching element is placed in a magnetic field of more than 1 T.

17. The system of claim 9, wherein said switching element and said superconducting magnet made of said oxide superconductor are electrically connected by a heat treatment for growing crystals of said oxide superconductor so that the overall resistance of an electrical circuit constituting said magnet system in a persistent current operation mode is not more than $10^{-9}$ $\Omega$.

# FIG. 1

## FIG. 2

# FIG. 3

EP 0 740 314 A1

FIG. 4

61

62

64

63

## FIG. 5

# FIG. 6

# FIG. 7

## FIG. 8

## FIG. 9

# FIG. 10

# FIG. 11

# FIG. 12

# FIG. 13

# FIG. 14

## FIG. 15

## FIG. 16

## FIG. 17

## FIG. 18

# FIG. 19

| European Patent Office | EUROPEAN SEARCH REPORT | Application Number EP 96 10 6363 |
| --- | --- | --- |

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
| --- | --- | --- | --- |
| X | US-A-4 816 962 (YAMADA TADATOSHI  ET AL) 28 March 1989 * column 4, line 5 - line 42; figure 4 * | 1,4 | H01F6/00 |
| A | US-A-5 394 129 (OBASIH KEMAKOLAM M  ET AL) 28 February 1995 * abstract; figures * | 1,2,4,5 | |
| A | EP-A-0 645 830 (HITACHI LTD) 29 March 1995 * abstract; claim 7; figures * | 1,7 | |
| A | PATENT ABSTRACTS OF JAPAN vol. 95, no. 004 & JP-A-07 106644 (HITACHI LTD), 21 April 1995, * abstract * | 1,8 | |
| A | EP-A-0 627 773 (HITACHI LTD) 7 December 1994 * claim 5 * | 3,6,7 | |
| A | US-A-4 369 636 (PURCELL JOHN R ET AL) 25 January 1983 * abstract * | 9 | TECHNICAL FIELDS SEARCHED (Int.Cl.6) H01F H02H |
| A | PATENT ABSTRACTS OF JAPAN vol. 011, no. 249 (E-532), 13 August 1987 & JP-A-62 060280 (TOSHIBA CORP), 16 March 1987, * abstract * | | |
| A | PATENT ABSTRACTS OF JAPAN vol. 013, no. 220 (E-762), 23 May 1989 & JP-A-01 032604 (TOSHIBA CORP), 2 February 1989, * abstract * | | |

The present search report has been drawn up for all claims

| Place of search | Date of completion of the search | Examiner |
| --- | --- | --- |
| THE HAGUE | 2 August 1996 | Marti Almeda, R |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)